# DEMANDE DE BREVET EUROPEEN

(11) **EP 4 766 057 A1**
(43) Date de publication de la demande: **24.06.2026**
(21) Numéro de dépôt: 25221904.3
(22) Date de dépôt: 09.12.2025
(51) Int. Cl.: H05K 7/20

(54) **ENSEMBLE ÉLECTRONIQUE COMPRENANT AU MOINS UN COMPOSANT ÉLECTRONIQUE ET UN DISPOSITIF DE REFROIDISSEMENT COMPORTANT UN ORGANE DE POSITIONNEMENT**

(30) Priorité: 17.12.2024 FR 2414408
(71) Demandeur: Valeo eAutomotive Germany GmbH, 91056 Erlangen (DE)
(72) Inventeur: BILTERYST, Pierre-Yves, 62630 Etaples-sur-Mer (FR); LEFOL, Guillaume, 62630 Etaples-sur-Mer (FR); REDON, Vincent, 62630 Etaples-sur-Mer (FR)
(74) Mandataire: Valeo Powertrain Systems

(57) **Abrégé**

L'invention concerne un ensemble électronique comprenant au moins un composant électronique (6), un dispositif de refroidissement (2) dudit composant électronique comprenant une plaque de refroidissement (4), ledit composant électronique (6) étant disposé sur ladite plaque de refroidissement (4) dans au moins une zone d'échange thermique (Z, Z1, Z2, Z3), la zone d'échange thermique (Z, Z1, Z2, Z3) étant une portion plane (10) de la plaque de refroidissement (4), l'ensemble électronique comportant par ailleurs au moins un moyen d'attache thermique (8) interposé entre la zone d'échange thermique (Z, Z1, Z2, Z3) et le composant électronique (6), la plaque de refroidissement (4) étant caractérisée en ce que des moyens de centrage (12) sont disposés sur le pourtour de la zone d'échange thermique (Z) de façon à maintenir le moyen d'attache thermique (8) et/ou le composant électronique (6) au sein de la zone d'échange thermique (Z).

## Description

La présente invention se rapporte au domaine des ensembles électroniques de véhicules automobiles, et notamment des dispositifs de refroidissement de composants électroniques associés à ces ensembles électroniques.

Les ensembles électroniques de véhicules automobiles, électriques ou hybrides, comprennent une pluralité de composants électroniques, tels que des modules de puissance, des bobines ou des capacités, sans que cette liste soit exhaustive. Ces composants électroniques produisent de la chaleur lors de leurs utilisations, et cette élévation de température, lorsqu'elle n'est pas contrôlée risque d'endommager les composants électroniques et donc de réduire la durée de vie du système électronique correspondant.

Notamment le module de puissance fait partie des composants électroniques produisant la plaque grande quantité de chaleur. Le module de puissance comprend un boîtier au sein duquel sont disposées côte à côte des puces électroniques. Le boîtier comporte un socle permettant de supporter des puces électroniques et une paroi de recouvrement qui recouvre les puces et qui forme, en combinaison avec le socle, un volume interne dans lequel s'étend les puces. Les puces sont connectées à des broches de connexion électriques qui s'étendent à l'extérieur du module de puissance, notamment pour permettre le raccordement électrique des puces électroniques, logées à l'intérieur du boîtier, à un réseau électrique.

Pour prévenir le risque de dysfonctionnement dû à une température trop élevée, il est connu d'associer aux composants électroniques, et notamment aux modules de puissance, un dispositif de refroidissement configuré pour permettre l'évacuation de calories.

Un tel dispositif de refroidissement peut comprendre une plaque de refroidissement sur laquelle sont disposés les composants électroniques. Un fluide caloporteur peut circuler au sein de la plaque de refroidissement permettant ainsi un échange de calories au travers de la plaque de refroidissement entre les composants électroniques et le fluide caloporteur.

Il est connu de solidariser les modules de puissance à une plaque de refroidissement par un procédé de brasage avec un matériau d'interface thermique interposé entre chaque module de puissance et la plaque. Ces procédés comprennent une étape de positionnement au cours de laquelle on réalise le placement d'un moyen d'attache thermique tel qu'une graisse thermique ou une préforme sur la plaque de refroidissement et ensuite le placement du module de puissance sur ce moyen d'attache thermique. La plaque de refroidissement est par la suite placée dans une étuve puis refroidie afin de figer le module de puissance dans la position de celui-ci lors de son entrée dans l'étuve, par déformation appropriée et durcissement du moyen d'attache thermique. Lorsque ce moyen d'attache thermique est une graisse thermique, l'opération de positionnement avant étuve implique que le module de puissance vient écraser la graisse thermique et la répandre en surface de la plaque de refroidissement, le passage en étuve et le refroidissement permettant de polymériser la graisse thermique entre le module de puissance et la plaque de refroidissement. Lorsque ce moyen d'attache thermique est une préforme, l'opération de positionnement avant étuve implique de positionner correctement la préforme contre la plaque de refroidissement et de venir rapporter le module de puissance contre cette préforme, l'ensemble étant amené par la suite dans l'étuve pour réaliser la polymérisation de la préforme lorsque celle-ci est une pâte thermique et pour réaliser la fusion du métal lorsque la préforme est une plaque d'attache métallique.

Cette solution de montage peut être améliorée dans la mesure où les inventeurs ont pu constater que les moyens d'attache thermique et les modules de puissance pouvaient se déplacer lors de leur déplacement pour leur mise en place dans une étuve, et pouvait ainsi impliquer un mauvais positionnement du module de puissance par rapport à la plaque de refroidissement une fois l'ensemble sorti d'étuve, c'est-à-dire une position du module de puissance qui n'est pas centrée correctement sur un canal de circulation de fluide au sein de la plaque de refroidissement, ceci ayant pour effet de générer un échange thermique qui n'est pas optimal lors de la montée en température du système et également engendrer des problèmes de montabilité vis à vis de la carte de pilotage via des broches de contrôle des modules de puissance.

La présente invention s'inscrit dans ce contexte et vise à proposer un ensemble électronique équipé d'un dispositif de refroidissement sur lequel le moyen d'attache thermique et/ou le composant électronique, notamment un module de puissance, est maintenu dans une position souhaitée.

La présente invention propose un ensemble électronique comprenant au moins un composant électronique, un dispositif de refroidissement dudit composant électronique comprenant une plaque de refroidissement, ledit composant électronique étant disposé sur ladite plaque de refroidissement dans au moins une zone d'échange thermique, la zone d'échange thermique étant une portion plane de la plaque de refroidissement, l'ensemble électronique comportant par ailleurs au moins un moyen d'attache thermique interposé entre la zone d'échange thermique et le composant électronique, la plaque de refroidissement étant caractérisé en ce que des moyens de centrage sont disposés sur le pourtour de la zone d'échange thermique de façon à maintenir le moyen d'attache thermique et/ou le composant électronique au sein de la zone d'échange thermique.

Le dispositif de refroidissement d'un système électronique selon l'invention, apte à équiper un véhicule automobile électrique, a notamment pour fonction de transmettre de la chaleur dégagée par le fonctionnement d'un composant électronique dudit système vers un circuit de refroidissement compris dans le véhicule. Ce dispositif de refroidissement est ici caractérisé par la présence d'une plaque de refroidissement au sein de laquelle est apte à circuler un fluide caloporteur et qui présente une zone d'échange thermique contre laquelle est fixé un composant électronique à refroidir, par l'intermédiaire d'un moyen d'attache thermique qui permet l'arrêt en position du composant électronique et qui permet, ou améliore, l'échange thermique entre le composant électronique et la plaque de refroidissement.

Le moyen d'attache thermique et le composant électronique associé sont disposés sur la plaque de refroidissement dans une zone d'échange thermique, cette zone d'échange thermique étant notamment choisie par la proximité d'un canal de passage de fluide caloporteur de l'autre côté de la paroi portant cette zone d'échange thermique. La zone d'échange thermique est formée d'au moins une portion plane ayant des dimensions égales ou supérieures aux dimensions correspondantes du moyen d'attache thermique. La planéité de ladite portion plane permet le plaquage et le maintien stable du composant électronique sur la plaque de refroidissement.

Selon une autre caractéristique optionnelle de l'invention, le moyen d'attache thermique est formé d'une préforme ou d'une pâte thermique.

La préforme peut être une plaque, notamment une plaque métallique, notamment une plaque métallique rigide, permettant de rendre le module de puissance solidaire de la plaque de refroidissement après passage en étuve. La préforme peut être une plaque d'un matériau d'interface thermique de type plastique ou composite, et par exemple du silicone La préforme peut être, de dimensions sensiblement constantes au moins avant le passage en étuve.

La pâte thermique a pour effet de s'assurer d'une surface de contact sans poche d'air entre la plaque de refroidissement et le composant électronique. La pâte thermique est visqueuse dans la plage de température du procédé d'assemblage. La pâte thermique présente une viscosité plus faible que celle d'une plaque métallique. La pâte thermique peut fluer, notamment sous l'effet d'une contrainte appliquée par le composant électronique. La pâte peut prendre la forme d'une graisse thermique. Cette pâte thermique est configurée pour être disposée dans la zone d'échange thermique, puis être écrasée et répartie par le composant électronique sur la plaque de refroidissement, définis la zone d'échange thermique. Lorsqu'une pâte thermique est utilisée les moyens de centrage sont alors configurés pour faciliter uniquement le positionnement et le blocage du composant électronique.

Selon une autre caractéristique optionnelle de l'invention, la plaque de refroidissement participe à délimiter un circuit de refroidissement. La plaque de refroidissement est alors au contact du fluide caloporteur.

L'assemblage de la plaque de refroidissement, du moyen d'attache thermique et du composant électronique est obtenu par un passage en étuve à une température permettant après repos la polymérisation ou le brasage du moyen d'attache thermique. Le moyen d'attache thermique peut se dilater lorsque celui-ci est chauffé et se colle au module de puissance. Lorsque l'assemblage est redescendu en température le moyen d'attache thermique est figé entre le module de puissance et la plaque de refroidissement.

L'ensemble peut être dépourvu de moyen de fixation entre le composant électronique et le dispositif de refroidissement, autre que le moyen d'attache thermique, lorsque ledit moyen d'attache thermique est une plaque métallique. Ce type de fixation permet de solidariser le composant électronique et la plaque de refroidissement sans ajouter de moyen de fixation tel que des vis ou des rivets. De plus le moyen d'attache thermique peut permettre d'améliorer la conductivité thermique entre le module de puissance et la plaque de refroidissement.

Les moyens de centrage présents sur la plaque de refroidissement sont agencés sur le pourtour de la zone d'échange thermique, qui correspond à la zone où l'on souhaite que le composant électronique soit positionné de façon pérenne après le passage en étuve, et par exemple la portion plane contre laquelle il est avantageux de faire reposer le composant électronique.

Les moyens de centrage sont disposés de telle façon que le moyen d'attache thermique et/ou le composant électronique soit maintenu en position sur la portion plane de la zone d'échange thermique lors du transport de l'assemblage vers l'étuve, à un moment du procédé d'assemblage où le composant électronique, et le cas échéant le moyen d'attache thermique, n'est pas fixé sur la plaque de refroidissement. En d'autres termes, la présence des moyens de centrage offre la possibilité de réduire le risque de déplacement du moyen d'attache thermique dans la zone d'échange thermique avant que la plaque de refroidissement ait été placée en étuve.

Dans un autre mode de réalisation, le composant électronique est bloqué par les moyens de centrage. Notamment, dans un mode de réalisation où le moyen d'attache thermique n'est pas réalisé par une préforme mais par la pâte thermique, ou graisse thermique, qui est un matériau visqueux. Le moyen d'attache thermique est alors disposé dans la zone d'échange thermique sans positionnement précis, pour être ensuite écrasé par le composant électronique. Il importe ainsi selon ce mode de réalisation, puisque le moyen d'attache thermique peut bouger, que le composant électronique soit bloqué par les moyens de centrage.

Selon une caractéristique optionnelle de l'invention, les moyens de centrage bloquent des mouvements de translation du moyen d'attache thermique et/ou du composant électronique, selon deux directions de centrage perpendiculaires d'un repère parallèle à la portion plane. En variante, les moyens de centrage bloquent des mouvements de translation du moyen d'attache thermique et/ou du composant électronique, selon une unique direction de centrage perpendiculaires d'un repère parallèle à la portion plane :
Selon une caractéristique optionnelle de l'invention, au moins deux moyens de centrage sont disposés en opposition de part et d'autre de la zone d'échange thermique selon l'une desdites directions de centrage. Lorsque chaque moyen de centrage bloque les mouvements dans une unique direction, alors quatre moyens sont nécessaires. Les moyens de centrage peuvent ainsi bloquer la translation dans les deux sens selon une direction donnée.

Dans une variante de réalisation, les moyens de centrage sont disposés aux quatre coins de la zone d'échange thermique. Dans une variante de réalisation, les moyens de centrage sont disposés sur chacun des bords de la zone d'échange thermique. Les bords peuvent ainsi former le pourtour de la zone d'échange thermique.

Dans ces variantes, la zone d'échange thermique peut notamment présenter une forme de quadrilatère, dont les dimensions sont similaires à celles de la forme de quadrilatère du moyen d'attache thermique et/ou du composant électronique : Des zones d'échappement de matière peuvent être prévus, notamment sur un bord, notamment sur plusieurs bords, notamment sur tos les bords du pourtour.

Selon une caractéristique optionnelle de l'invention, le moyen d'attache thermique et/ou le composant électronique présente au moins une dimension légèrement inférieure à la distance correspondante entre deux moyens de centrage en opposition.

En d'autres termes, la dimension du moyen d'attache thermique et/ou du composant électronique selon une direction donnée, par exemple sa longueur ou sa largeur dans le cas d'une forme de quadrilatère, est définie par l'écartement des deux moyens de centrage disposés en regard l'un de l'autre selon cette direction, afin qu'il puisse être positionné contre la portion plane de la plaque de refroidissement sans être gêné par la présence des moyens de centrage. En cela, la longueur et la largeur du moyen d'attache thermique et/ou du composant électronique sont inférieures à celles de la zone d'échange thermique. Par ailleurs, étant donné que les moyens de centrage bloquent le moyen d'attache thermique, respectivement le composant électronique, et donc qu'il convient que ce dernier ne bouge pas ou peu lors de sa manipulation une fois qu'il se retrouve entre les moyens de centrage, la longueur et la largeur du moyen d'attache thermique et/ou du composant électronique ne sont que légèrement inférieures, c'est-à-dire sensiblement égales, à celles de la zone d'échange thermique.

Selon une caractéristique optionnelle de l'invention, au moins l'un des moyens de centrage comporte un corps principal qui présente une hauteur, mesurée perpendiculairement à la portion plane de la zone d'échange thermique, qui est supérieure à la hauteur correspondante du moyen d'attache thermique :
De la sorte, on s'assure que le corps principal du moyen de centrage bloque le moyen d'attache thermique dans son déplacement en translation le long de la portion plane de la zone d'échange thermique, en évitant que celui-ci puisse passer au-dessus du moyen de centrage.

Selon une caractéristique optionnelle de l'invention, l'ensemble électronique présente un doigt de butée. Le doigt de butée s'étend entre le composant électronique et la portion plane de la plaque de refroidissement. De la sorte, on s'assure que le composant électronique soit à une distance donnée de la plaque de refroidissement lorsqu'il est positionné dans la zone d'échange thermique, cette distance étant déterminée pour un taux d'écrasement optimal du moyen d'attache thermique interposé entre le composant électronique et la plaque de refroidissement.

Selon une caractéristique optionnelle de l'invention, le moyen de centrage vient de matière avec le doigt de butée. Le doigt de butée peut faire saillie du corps principal vers le centre de la zone d'échange thermique de la plaque de refroidissement

Selon une autre caractéristique optionnelle de l'invention, le corps principal du moyen de centrage présente une hauteur plus importante que celle du doigt de butée.

A titre d'exemple non limitatif, le doigt de butée présente une hauteur de 200 microns. Cette dimension correspond à la hauteur ou épaisseur optimale du moyen d'attache thermique qu'il convient de conserver après avoir plaqué le composant électronique sur la zone d'échange thermique, notamment pour que suffisamment de moyen d'attache thermique soit encore interposé entre la plaque de refroidissement et le composant électronique avant passage en étuve pour permettre la fixation du composant électronique et l'échange thermique optimal.

Selon une caractéristique optionnelle de l'invention, le composant électronique comprend au moins une contre forme configurée pour recevoir le moyen de centrage.

Le moyen de centrage peut alors permettre de centrer le composant électronique en même temps qu'il permet de centrer le moyen d'attache thermique, et notamment lorsque le composant électronique présente des dimensions plus grandes que celles du moyen de fixation thermique.

Selon une caractéristique optionnelle de l'invention, le composant électronique comporte au moins deux contres formes parmi lesquelles deux contres formes réalisées sur des faces opposées du composant électronique.

Selon une autre caractéristique de l'invention, les moyens de centrage sont des éléments rapportés sur la plaque de refroidissement.

Les moyens de centrage peuvent par exemple prendre la forme d'ergots réalisés distinctement de la plaque de refroidissement et configurés pour être insérés dans des trous réalisés dans la plaque de refroidissement et permettant le positionnement des moyens de centrage.

Selon une autre caractéristique optionnelle de l'invention, les moyens de centrage sont réalisés d'un seul tenant avec la plaque de refroidissement.

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :

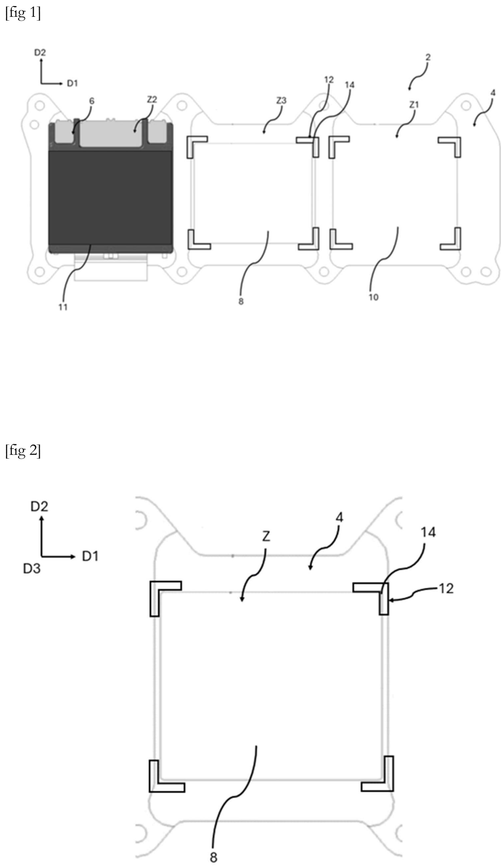

[fig 1] est une représentation schématique partielle vue du dessus d'un dispositif de refroidissement de composant électronique, ici pour un ensemble électronique formant un système de commutation de puissance d'un véhicule automobile, rendant notamment visibles une portion d'une plaque de refroidissement et trois zones d'échange thermiques voisines avec l'une des zones qui comporte un composant électronique, une autre zone qui ne comporte qu'un moyen d'attache thermique non recouvert par un composant électronique, et une autre zone vierge ; [fig 2] est une représentation schématique vue du dessus d'une zone d'échange thermique formée comprenant un premier mode de réalisation de disposition des moyens de centrage ;
[fig 3] est une représentation schématique vue du dessus d'un deuxième mode de réalisation du dispositif de refroidissement, avec une zone d'échange thermique dans laquelle des moyens de centrage sont disposés spécifiquement ;
[fig 4] est une représentation schématique vue du dessus d'un troisième mode de réalisation du dispositif de refroidissement, avec une zone d'échange thermique dans laquelle des moyens de centrage sont disposés spécifiquement ;
[fig 5] est une représentation schématique d'une vue de coupe de l'assemblage de la plaque de refroidissement, du moyen d'attache thermique et du composant électronique, rendant visible l'interaction du moyen d'attache thermique et d'un des moyens de centrage ;
[fig 6] est une représentation schématique vue du dessus d'une zone d'échange thermique dans une variante de réalisation dans laquelle des moyens de centrage viennent de matière avec un doigt de butée s'étendant vers l'intérieur de la zone d'échange thermique ;
[fig 7] est une représentation schématique d'une vue de coupe de l'assemblage de la plaque de refroidissement, du moyen d'attache thermique et du module de puissance avec une contre forme comprise dans le module de puissance.

La figure 1 est une représentation schématique d'un dispositif de refroidissement 2 apte à équiper un véhicule automobile et notamment un véhicule électrique ou hybride, sans toutefois que cette application soit limitative de l'invention.

Le dispositif de refroidissement 2 comprend une plaque de refroidissement 4 participant à délimiter un circuit de refroidissement non représenté sur les figures et au sein duquel un fluide caloporteur est apte à circuler. Des échanges de calories entre le fluide caloporteur et des composants électroniques du véhicule électrique sont réalisés au travers de la plaque de refroidissement 4. En d'autres termes, les composants électroniques sont aptes à transférer de la chaleur au fluide caloporteur via une paroi de la plaque de refroidissement.

La plaque de refroidissement 4 comprend ici trois zones d'échange thermique Z1, Z2, Z3 configurées pour recevoir des composants électroniques tels que des bobines, des capacités ou encore, tel qu'illustré ici des modules de puissance, l'échange thermique étant réalisé entre le fluide caloporteur et un composant électronique au niveau de la plaque de refroidissement 4 dans une zone d'échange thermique Z1, Z2, Z3 correspondante. Dans le dispositif de refroidissement 2 représenté figure 1, les trois zones d'échange thermique Z1, Z2, Z3 sont représentées dans une configuration qui a été rendue différente pour chaque zone à dessein, pour rendre visible une zone d'échange thermique Z1 vierge, une zone d'échange thermique Z3 recouverte par un moyen d'attache thermique 8 préalablement au positionnement d'un composant électronique par-dessus, et enfin une zone d'échange thermique Z2 pourvue d'un composant électronique recouvrant le moyen d'attache thermique 8.

La première zone d'échange thermique Z1, ici vierge, permet d'illustrer une portion plane 10 de la zone d'échange thermique. Chaque zone d'échange thermique comprend une portion plane 10 identique d'une zone d'échange thermique à l'autre, mais seule celle de la première zone d'échange thermique Z1, ici vierge, est visible. La portion plane 10 présente une forme de quadrilatère, ici rectangulaire, qui présente sensiblement la même forme que celle des composants électroniques et des moyens d'attache thermique 8, sans que ceci soit limitatif de l'invention.

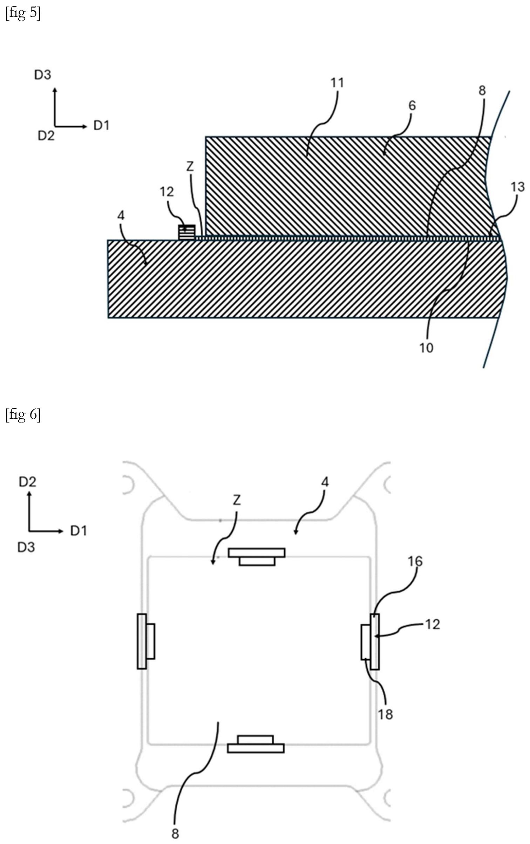

La deuxième zone d'échange thermique Z2 est ici recouverte d'un module de puissance formant le composant électronique 6 à refroidir. Le module de puissance 6 comprend un boitier 11 qui présente une forme rectangulaire. Le boitier 11 comprend une face 13 en regard de la plaque de refroidissement 4, visible sur la figure 5.

Le boitier 11 loge des puces électroniques dont le fonctionnement dégage des calories qu'il convient d'évacuer à travers la paroi du boîtier 11 et la plaque de refroidissement 4 pour que ces calories soient captées par le fluide caloporteur circulant au sein de la plaque de refroidissement 4.

Le module de puissance 6 n'est pas en contact direct avec la plaque de refroidissement 4, un moyen d'attache thermique 8 visible dans la troisième zone d'échange thermique Z3 de la figure 1 étant disposé entre le module de puissance 6 et la plaque de refroidissement 4. Le moyen d'attache thermique 8 a pour fonction de former un système de fixation permettant la solidarisation du module de puissance 6 à la plaque de refroidissement 4. Notamment, le moyen d'attache thermique 8 est configuré pour polymériser ou pour braser après et/ou pendant le passage dans une étuve. Le moyen d'attache thermique 8 a également pour fonction d'augmenter la conductivité thermique entre le boîtier 11 du module de puissance 6 et la plaque de refroidissement 4, notamment en évitant la présence de poches d'air entre eux. Ainsi l'échange de chaleur entre la face 13 du boitier 11 du module de puissance 6 et la portion plane 10 de la zone d'échange thermique Z1, Z2, Z3 est optimal.

Selon un premier mode de réalisation du moyen d'attache thermique 8, le moyen d'attache thermique 8 est une préforme dont les dimensions restent sensiblement constantes avant le passage en étuve de l'assemblage formé par le positionnement de la préforme sur la plaque de refroidissement 4 puis du module de puissance 6 sur la préforme. Cette préforme peut-être une plaque métallique ou une plaque d'un matériau d'interface thermique de type plastique ou composite, et par exemple du silicone. La préforme peut s'étendre sur l'intégralité de la portion plane 10 de la zone d'échange thermique. La préforme présente une surface au moins supérieure à la surface de la face 13 du module de puissance 6 en regard de la plaque de refroidissement 4. Une pluralité de préformes peuvent être disposées sur la portion plane 10 d'une zone d'échange thermique de sorte que le moyen d'attache thermique 8 formé par cette pluralité de préformes présente une surface supérieure à la surface de la face 13 du module de puissance 6. Selon un deuxième mode de réalisation du moyen d'attache thermique 8, le moyen d'attache thermique 8 est une pâte thermique.

Tel qu'évoqué, la préforme formant le moyen d'attache thermique 8 est configurée pour rendre le module de puissance 6 solidaire de la plaque de refroidissement 4. En effet, l'assemblage formé par la plaque de refroidissement 4, le moyen d'attache thermique 8 et le module de puissance 6 est configuré pour être passé dans une étuve afin de figer l'assemblage. Lors du transport de la plaque de refroidissement dans l'étuve, la préforme formant le moyen d'attache thermique 8 ainsi que le module de puissance 6 sont susceptibles de glisser sur la plaque de refroidissement 4, selon deux directions D1, D2 d'un repère orthonormé parallèle à la portion plane 10 de la zone d'échange thermique Z1, Z2, Z3.

Il convient de s'assurer que le moyen d'attache thermique 8 et/ou le module de puissance 6 restent dans les zones d'échange thermique Z1, Z2, Z3 avant le passage en étuve et les zones d'échange thermique Z1, Z2, Z3 d'un dispositif de refroidissement selon l'invention comprennent des moyens de centrage 12 permettant de bloquer le déplacement en translation des préformes positionnées dans lesdites zones d'échange thermique.

Les moyens de centrage 12 sont disposés autour de la zone d'échange thermique Z1, Z2, Z3 de sorte que lorsque le moyen d'attache thermique est positionné contre la plaque de refroidissement 4 et que les modules de puissance 6 sont disposés contre les moyens d'attache thermique 8. Les moyens de centrage 12 sont configurés pour réduire les mouvements possibles du moyen d'attache thermique 8 et notamment les mouvements du moyen d'attache thermique 8 le long de la plaque de refroidissement 4 avant le passage dans l'étuve.

Les moyens de centrage 12 sont disposés sur le pourtour d'au moins une zone d'échange thermique Z1, Z2, Z3, ici sur le pourtour de chacune des zones d'échange thermique.

Les moyens de centrage 12 sont disposés sur le pourtour de la zone d'échange thermique, et notamment sur le pourtour de la portion plane 10 pour délimiter la zone dans laquelle doit être positionné le moyen d'attache thermique 8 et par suite le module de puissance 6.

Les moyens de centrage 12 sont positionnés à distance l'un de l'autre selon une direction parallèle au plan dans lequel s'étend la portion plane 10 de la zone d'échange thermique Z1, Z2, Z3. Cette distance entre les moyens de centrage 12 est légèrement inférieure à la dimension correspondante d'un moyen d'attache thermique 8, ou d'un module de puissance 6, ici d'un moyen d'attache thermique 8 comme visible sur la figure 1 dans la deuxième zone d'échange thermique Z2.

De la sorte, on bloque la translation dans cette direction du composant disposé entre les moyens de centrage 12, ici le moyen d'attache thermique 8.

Les moyens de centrage 12 peuvent être réalisés par continuité de matière avec la plaque de refroidissement 4. Un tel mode de fabrication permet de s'assurer du positionnement exact du moyen d'attache thermique 8 disposé sur la plaque de refroidissement 4 à plus grande échelle. En effet, la plaque de refroidissement 4 étant moulée, la réalisation des moyens de centrage 12 est alors exact tant que le même moule est utilisé.

Les moyens de centrage 12 peuvent aussi être disposés sur la plaque de refroidissement 4 par un opérateur, selon un autre mode de fabrication. Les moyens de centrages sont réalisés distinctement de la plaque de refroidissement et l'opérateur rend les moyens de centrage 12 solidaires de la plaque de refroidissement 4 en faisant coopérer chaque moyen de centrage avec un ergot compris sur la plaque de refroidissement 4 par exemple. Un tel mode de fabrication permet d'adapter l'écart entre les moyens de centrage 12 de façon à s'adapter à différentes tailles du moyen d'attache thermique 8 que l'on souhaite bloquer.

Divers modes de réalisations des moyens de centrage 12 vont être présentés dans les figures 2 à 6.

La figure 2 présente un premier mode de réalisation des moyens de centrage 12 dans lequel les moyens de centrage 12 sont disposés au coin de la zone d'échange thermique Z, et ces moyens de centrage 12 forment des butées pour chacun des coins 14 du moyen d'attache thermique 8 lorsque ce dernier est rapporté sur la plaque de refroidissement 4 sur la zone d'échange thermique Z. Le moyen d'attache thermique 8 présente ici une forme, de sorte que quatre moyens de centrage 12 sont disposés sur le pourtour de la zone d'échange thermique Z. Les moyens de centrage 12 présentent une forme d'équerre.

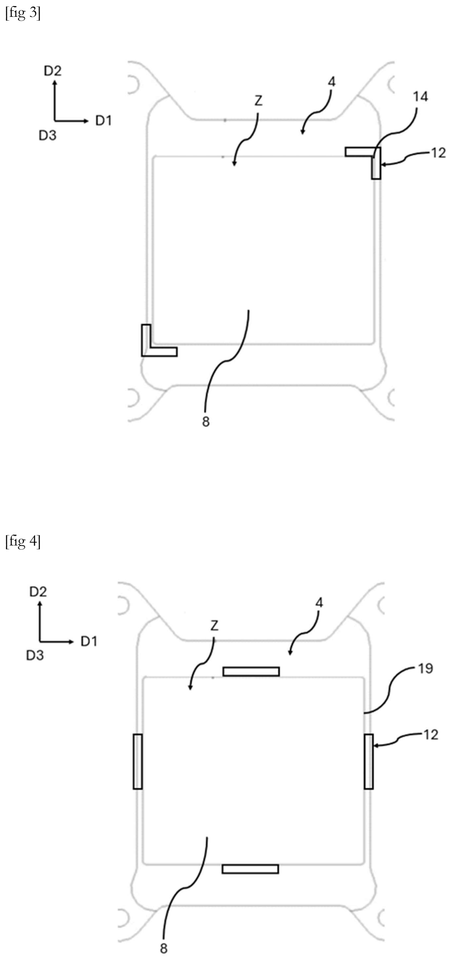

La figure 3 présente un deuxième mode de réalisation des moyens de centrage 12 dans lequel le nombre de moyens de centrage 12 est réduit tout en garantissant le positionnement du moyen d'attache thermique 8.

Selon le deuxième mode de réalisation, les moyens de centrage 12 sont disposés à deux coins 14 du moyen d'attache thermique 8. Les deux moyens de centrage 12 sont opposés par rapport au moyen d'attache thermique 8. Les deux moyens de centrage 12 présentent, conformément à ce qui a été décrit en relation avec la figure 2, des formes d'équerre permettant ainsi de bloquer le déplacement du moyen d'attache thermique 8 et/ou du module de puissance 6 selon deux directions D1, D2 et dans les deux sens de chaque direction. Ce mode de réalisation permet de diviser par deux la quantité de moyen de centrage 12 pour bloquer les deux degrés de liberté du moyen d'attache thermique 8.

La figure 4 présente un troisième mode de réalisation des moyens de centrage 12. Dans le troisième mode de réalisation, les moyens de centrage 12 présente une forme de pavé droit.

Les moyens de centrage sont disposés sur le pourtour de la zone d'échange thermique, chaque moyen de centrage étant parallèle à un bord de la portion plane de la zone d'échange thermique. Les moyens de centrage 12 sont disposés face à des bords 16 du moyen d'attache thermique 8 lorsque ce dernier est positionné sur la zone d'échange thermique. Ainsi, quatre moyens de centrage 12 sont disposés autour du moyen d'attache thermique 8. Les côtés les plus longs du pavé droit sont parallèles aux bords 19 du moyen d'attache thermique 8 contre lequel s'étendent les moyens de centrage 12: Les moyens de centrage 12 selon le troisième mode de réalisation étant opposés deux à deux, ceux-ci sont aptes à bloquer le moyen d'attache thermique 8, et/ou le cas échéant le module de puissance 6, selon deux directions D1, D2 et les deux sens de chacune des directions.

La figure 5 est une vue de coupe d'un quelconque mode de réalisation présenté précédemment qui rend notamment visible la dimension verticale des éléments précédemment décrits. Le moyen de centrage 12 présente une hauteur égale ou supérieure à la hauteur du moyen d'attache thermique 8, la hauteur étant définie selon la direction perpendiculaire à la portion plane 10 de la zone d'échange thermique Z. Etant donné que le moyen de centrage 12 présente une hauteur égale ou supérieure au moyen d'attache thermique 8, celui-ci est bloqué puisqu'il lui est impossible de passer par-dessus le moyen de centrage 12. De plus, dans ce mode de réalisation, la surface de la face 13 du boitier 11 du module de puissance 6 est inférieure à la surface du moyen d'attache thermique 8. Ainsi, le module de puissance 6 peut aussi être bloqué par le moyen de centrage 12 lorsque celui-ci présente une épaisseur supérieure au moyen d'attache thermique 8, le module de puissance 6 venant reposer contre le moyen d'attache thermique.

La figure 6 est une représentation schématique d'un deuxième aspect de l'invention pouvant être appliqué à l'un ou l'autre des modes de réalisation décrits précédemment.

Au moins un moyen de centrage 12, ici tous les moyens de centrage 12, présente un corps principal 16 conformément à ce qui a été décrit dans les modes de réalisation précédemment évoqués. Un doigt de butée 18 s'étend depuis le corps principal 16 de chaque moyen de centrage 12 vers le centre de la zone d'échange thermique Z.

Les doigts de butée 18 forment une butée verticale pour le module de puissance 6 lorsque celui-ci est positionné sur la zone d'échange thermique Z et qu'il vient en appui contre les doigts de butée 18. Les doigts de butée 18 maintiennent le module de puissance 6 parallèle à la portion plane 10 de la zone d'échange thermique Z, et à une distance déterminée de cette portion plane 10 qui correspond à la hauteur des doigts de butée 18.

Chacun des doigts de butée 18 associé à une zone d'échange thermique et au soutien d'un module de puissance 6 présente une même hauteur que celle des autres doigts de butée pour que la face du module de puissance 6 en regard de la portion plane 10 soit parallèle à cette dernière et qu'elle exerce une pression constante sur le moyen d'attache thermique 8.

Ainsi, ce mode de réalisation avec un doigt de butée est notamment intéressant lorsque le moyen d'attache thermique 8 est constitué d'une pâte thermique, ou graisse thermique, présentant une viscosité plus faible, en particulier plus faible qu'une préforme en forme de plaque métallique dont les dimensions sont sensiblement constantes pendant le procédé d'assemblage. La graisse thermique est répartie dans la zone d'échange thermique Z1, Z2, Z3 via l'écrasement du module de puissance 8 et le positionnement vertical du module de puissance 6 et l'épaisseur du moyen d'attache thermique 8 sont déterminés selon ce montage. Il est nécessaire pour le bon fonctionnement des composants électroniques que ceux-ci soient positionnés selon la hauteur prévue et il est nécessaire pour leur bon refroidissement que l'épaisseur de graisse thermique soit optimale. De ce fait, les doigts du butée 18 des moyens de centrage 12 permettent de définir un positionnement vertical du module de puissance 6 qui est le plus fidèle à un positionnement théorique permettant cette compression optimale de la graisse thermique.

En maintenant, via ces doigts de butée 18, le module de puissance 6 à une distance définie de la plaque de refroidissement 4, le moyen d'attache thermique 8 peut lui aussi avoir une épaisseur définie et continue sur l'intégralité de la zone d'échange thermique Z, de sorte que le moyen d'attache thermique 8 soit le plus efficace possible. L'épaisseur optimale du moyen d'attache thermique 8 est de 200 microns, et cette épaisseur peut être sensiblement constante sur l'intégralité de la zone d'échange thermique Z du fait d'un écrasement homogène du moyen d'attache thermique 8 par le module de puissance 6. Cette épaisseur contrôlée du moyen d'attache thermique 8 permet d'obtenir la meilleure fixation du module de puissance 6 à la plaque de refroidissement 4 tout en proposant le meilleur échange thermique entre le module de puissance 6 et la plaque de refroidissement 4. Après passage en étuve l'épaisseur reste donc optimale puisqu'il y a une quantité suffisante du moyen d'attache thermique 8 sous le module de puissance 6 sans avoir une épaisseur trop importante de celui-ci.

Du fait de la présence des doigts de butée 18, le moyen d'attache thermique 8 comprend des découpes assimilables à des cavités dans lesquelles les doigts de butée 18 sont aptes à s'étendre. De la sorte, les doigts de butée 18 permettent par la même occasion de centrer le moyen d'attache thermique 8.

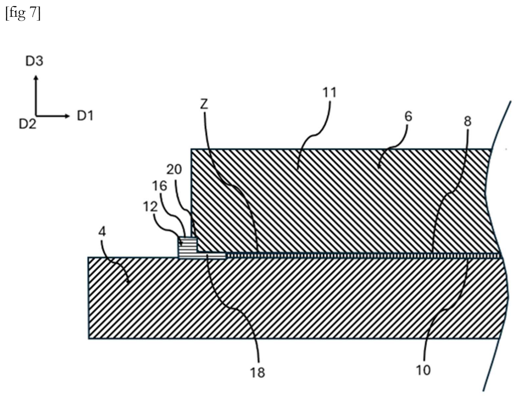

La figure 7 est une représentation schématique en vue de coupe d'un troisième aspect de l'invention dans lequel le module de puissance 6 comprend des contres formes 20. Les contres formes 20 sont disposées sur la face 13 du boitier 11 du module de puissance 6 en regard de la plaque de refroidissement 4 et sur une des faces latérales du module de puissance 6. Les contres formes 20 s'étendent vers l'intérieur du boitier 11 du module de puissance 6 formant ainsi respectivement une zone de réception d'un des moyens de centrage.

La contre forme 20 est configurée pour coopérer avec le corps principal 16 du moyen de centrage 12 et avec les doigts de butée 18. Ce mode de réalisation permet au boitier 11 du module de puissance de présenter une dimension légèrement inférieure à celle de l'écartement entre deux moyens de centrage 12 et les doigts de butée 18 assurent la fonction de bloquer le mouvement du moyen d'attache thermique 8 et/ou le mouvement du module de puissance 6.

Ce troisième aspect de l'invention est particulièrement avantageux lorsque le deuxième mode de réalisation du moyen d'attache thermique 8 est mis en œuvre puisque la graisse thermique ne présente pas de forme constante et qu'il convient de s'assurer que l'épaisseur de la graisse thermique après compression par le module de puissance 6 soit sensiblement homogène et suffisamment épaisse pour assurer son rôle de pont thermique.

Au moins deux contres formes 20 sont comprises sous le module de puissance 6, celles-ci étant opposés l'une à l'autre par rapport au module de puissance 6. Ces deux contres formes 20 permettent de bloquer les degrés de liberté du module de puissance 6 selon les deux directions D1, D2 parallèle à la portion plane 10 de la zone d'échange thermique Z et de bloquer la direction D3 perpendiculaire à la portion plane 10 selon un sens de la direction de D3.

L'invention, telle qu'elle vient d'être décrite, atteint bien le but qu'elle s'était fixé, et permet de proposer un dispositif de refroidissement de composant électronique assurant le positionnement du moyen d'attache thermique. Des variantes non décrites ici pourraient être mises en œuvre sans sortir du contexte de l'invention, dès lors que, conformément à l'invention, elles comprennent des moyens de centrage du moyen d'attache thermique conformément à l'invention.

## Revendications

1. Ensemble électronique comprenant au moins un composant électronique (6), un dispositif de refroidissement (2) dudit composant électronique comprenant une plaque de refroidissement (4), ledit composant électronique (6) étant disposé sur ladite plaque de refroidissement (4) dans au moins une zone d'échange thermique (Z, Z1, Z2, Z3), la zone d'échange thermique (Z, Z1, Z2, Z3) étant une portion plane (10) de la plaque de refroidissement (4), l'ensemble électronique comportant par ailleurs au moins un moyen d'attache thermique (8) interposé entre la zone d'échange thermique (Z, Z1, Z2, Z3) et le composant électronique (6), la plaque de refroidissement (4) étant **caractérisée en ce que** des moyens de centrage (12) sont disposés sur le pourtour de la zone d'échange thermique (Z) de façon à maintenir le moyen d'attache thermique (8) et/ou le composant électronique (6) au sein de la zone d'échange thermique (Z).

2. Ensemble électronique selon la revendication 1, dans lequel les moyens de centrage (12) bloquent des mouvements de translation du moyen d'attache thermique (8) et/ou du composant électronique (6), selon deux directions (D1, D2) de centrage perpendiculaires d'un repère parallèle à la portion plane (10).

3. Ensemble électronique selon l'une des revendications précédentes, dans lequel au moins l'un des moyens de centrage (12) comporte un corps principal (16) qui présente une hauteur, mesuré perpendiculairement à la portion plane (10) de la zone d'échange thermique (Z, Z1, Z2, Z3), qui est supérieure à la hauteur correspondante du moyen d'attache thermique (8).

4. Ensemble électronique selon la revendication 3, dans lequel le moyen de centrage (12) présente un doigt de butée (18) faisant saillie du corps principal (16) vers le centre de la zone d'échange thermique (Z, Z1, Z2, Z3) de la plaque de refroidissement (4).

5. Ensemble électronique selon la revendication précédente, dans lequel le corps principal (16) du moyen de centrage (12) présente une hauteur plus importante que celle du doigt de butée (18).

6. Ensemble électronique selon l'une quelconque des revendications précédentes, dans lequel le module de puissance (6) comprend au moins une contre forme (20) configurée pour recevoir le moyen de centrage (12).

7. Ensemble électronique selon l'une quelconque des revendications 1 à 6, dans lequel les moyens de centrage (12) sont des éléments rapportés à la plaque de refroidissement (4).

8. Ensemble électronique selon l'une des revendications 1 à 6, dans lequel les moyens de centrage (12) sont réalisés d'un seul tenant avec la plaque de refroidissement (4).

9. Ensemble électronique selon l'une quelconque des revendications précédentes, dans lequel le moyen d'attache thermique (8) est formé d'une pâte thermique ou d'une préforme, notamment une plaque.

10. Ensemble électronique selon l'une quelconque des revendications précédentes, dans lequel la plaque de refroidissement (4) participe à délimiter un circuit de refroidissement.
